# EUROPEAN PATENT APPLICATION

(11) **EP 0 777 324 A2**
(43) Date of publication of application: **04.06.1997**
(21) Application number: 96308448.8
(22) Date of filing: 21.11.1996
(51) Int. Cl.: H03G 1/00

(54) **Automatic gain control**

(30) Priority: 28.11.1995 GB 9524254
(71) Applicant: PLESSEY SEMICONDUCTORS LIMITED, Swindon, Wiltshire SN2 2QW (GB)
(72) Inventor: Clark, Christopher, Swindon, Wiltshire, SN5 9JG (GB)
(74) Representative: Waters, Jeffrey

(57) **Abstract**

An automatic gain control ofthe feedforward type operates by switching any combination of a cascaded series of switched gain amplifiers in dependence on a control (10), which could have as its output a multi-bit representation of a signal derived from the input as detected by a detector (3) and, in this case, the bit value of the multi-bit signal would control the switched gain of the respective amplifier between one of a series of amplifying values and a common value.

## Description

This invention relates to automatic gain controls.

It is an aim of the invention to produce a fast-acting automatic gain control (AGC). One area in which such an AGC is desirable is in local area networks (LANs) which operate at high data rates and hence high carrier frequencies.

LANs are used to communicate between, for example, a network of office equipment such as word processors, printers etc by means of radio transmissions rather than by wires. One limiting factor of such an environment is the typical echo time encountered, which depends on the size of the environment and the (fixed) speed of electromagnetic waves. A transmission from one piece of equipment to another is accordingly typically accompanied by a delayed echo transmission, and a typical delay is 250 nanoseconds (ns). At a data rate of around 1.5 megabits/second (Mb/s), each bit or symbol lasts a little over 600 ns, and it can be seen that each bit lasts long enough for the bit sequence to be detected even in the presence of an echo. Fading due to multipath will occur, but it can be compensated for by passing the intermediate frequency (IF) through a limiting amplifier before detection. The detector recovers the digital data from the modulated carrier.

When higher data rates are proposed, such as around 23 Mb/s, the typical echo delay of around 250 ns is around six times as great as the typical bit or symbol time of around 40 ns. More sophisticated techniques must be used to prevent problems from the echoes. In fact, the data, which is transmitted in bursts, contains in each burst a known (training) sequence), so that the received version of the sequence can be used to estimate the distorting effect of the environment (channel estimator), to enable this effect to be compensated for, in order to recover accurately the data transmitted. The received transmission (at IF level) must be amplified to occupy the full dynamic range of ADCs. However, this time, multipath may cause complete cancellation/constructive interference of the LAN radio transmission in a way which varies with frequency, and a limiting amplifier cannot be used. This problem is overcome by each data burst including a low data rate header for which the bit period is greater than a typical echo delay during which the gain of the IF amplifier can be adjusted to match the ADC dynamic range. The header is of short duration since each data burst must also carry the data in addition to a training sequence, and hence a fast acting AGC is required.

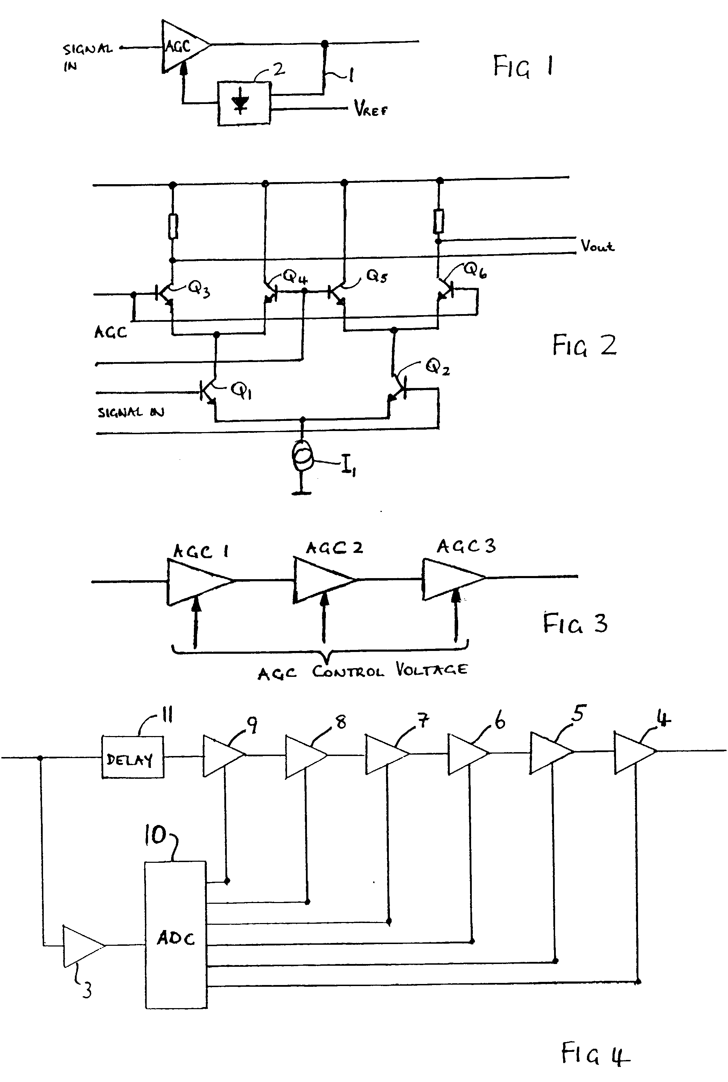

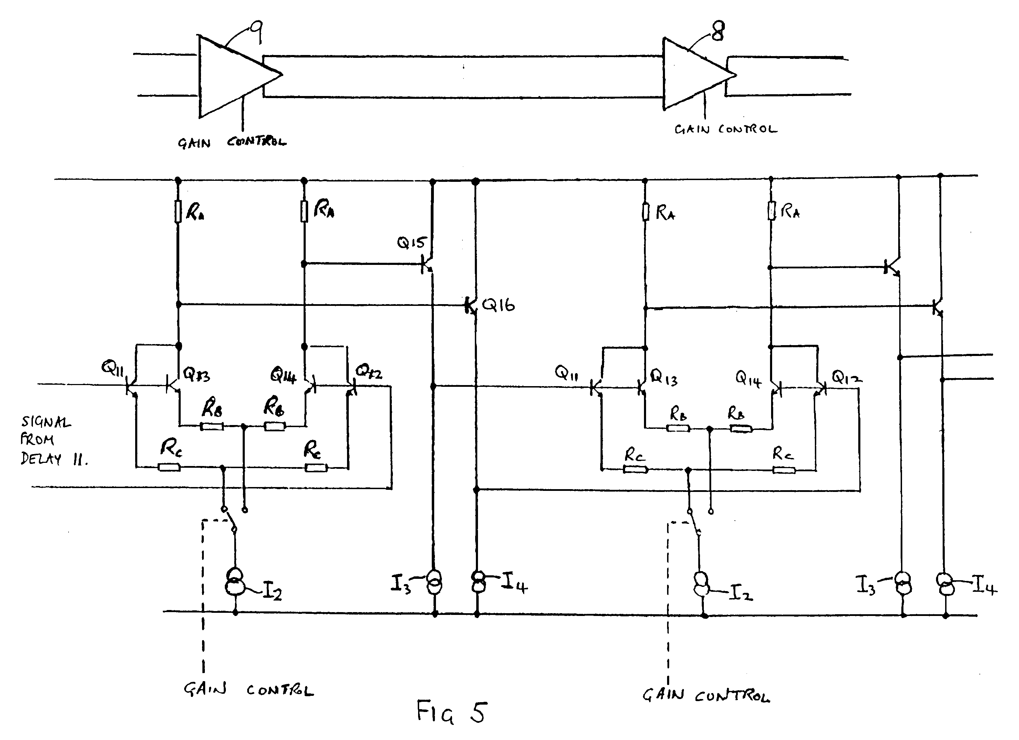

A conventional known AGC amplifier configuration suitable for being integrated is shown in Figures 1 and 2. The output of the AGC amplifier is brought to a level referred to V_{REF} by means of a closed feedback loop 1 which includes a detector 2 which controls the gain ofthe AGC amplifier. The known circuit of Figure 1 is shown in simplified form in Figure 2, and consists of a differential pair of transistors Q1, Q2 which receive a balanced input signal, biased by means of a current generator I₁. The AGC is arranged in the collector circuit ofthe transistors Q1 and Q2 and consists of respective pairs of transistors Q3, Q4 and Q5, Q6 which modify the gain produced by Q1, Q2 in accordance with the detected feedback signal. The circuit is known as a Gilbert Cell.

It is difficult to use the known circuit of Figures 1 and 2 in a system where a fast-acting AGC is required, because of the undesirable time delay and phase shift created by the closed loop, which can cause stability problems or undue settling time.

For this reason, it has been proposed to use an open loop i.e. feedforward AGC, in which the detector is arranged in the input path to the AGC amplifier. In addition to use in the LAN environment outlined above, such a fast acting AGC would be of particular benefit within a communications or computer network utilising a modulation scheme with an appreciable amplitude modulated component, as in for instance Direct Sequence Spread Systems. However, such a configuration suffers from problems e.g. compensation for variations in temperature is relatively complicated.

Another requirement of an AGC for a LAN environment is a large gain control range, and it might therefore be thought that an open loop system employing several stages, as shown in fragmentary form in Figure 3, would be desirable. However, this introduces additional technical problems because it is not always desirable for the gain of multiple stages to be changed simultaneously, and it would be necessary to offset the gain responses so that first one stage responded, then a second stage and finally the third stage. This introduces technical complication.

A pulse levelling device has been proposed (US-A-3 887 875) comprising a plurality of switched gain attenuators arranged in cascade. The attenuation of each of the attenuators is switched between one of a series of values and a common value, in response to the amplitude of each pulse received, in order to affect the amplitude of the next succeeding pulse received.

The invention provides an automatic gain control comprising an input, a detector connected to the input and arranged to detect the input signal, an AGC amplifier comprising a plurality of switched gain amplifiers arranged in cascade, the gain of each of which can be switched between one of a series of values and a common value, in response to signals derived from the output of the detector, and a delay connected in series between the input and the AGC amplifier to compensate for the delay between the instantaneous value of the input signal and the switching of the amplifiers in response to that instantaneous value.

The use of the delay in the feedforward configuration, permits fast fluctuations in signal strength to be compensated for, and the plurality of switched gain amplifiers permits the gain to be controlled over a wide range in a simple manner which avoids the complications of offsetting gain from different stages.

Advantageously, the detector has a log/linear input/output characteristic, and the gain of the switched gain amplifier can then be controlled in response to the bit value on a respective line of the output of a multi-bit ADC having as its input a signal derived from the output of the detector. In addition to being a simple arrangement, this provides a digitised received signal strength (RSSI) output.

Advantageously, the switched gain amplifiers each include a bipolar transistor in common emitter configuration, the bias current of which is proportional to absolute temperature (PTAT). With this arrangement it is thus possible to temperature compensate the AGC in a simple manner.

The invention will now be described by way of example, with reference to the accompanying drawings, in which:
Figure 4 shows a general realisation of the AGC;
Figure 5 shows the switched gain amplifiers of two consecutive stages in more detail;
Figure 6 shows the detector of Figure 4 in more detail; and
Figure 7 shows the output voltage/input signal strength characteristic of the detector of Figure 6.

Like reference numerals have been given to like components throughout all the figures.

Referring to Figure 4, an automatic gain control in a LAN transceiver comprises a detector 3 arranged to detect the input signal to an AGC amplifier consisting of a plurality of switched gain amplifiers 4-9 arranged in cascade. The gain of each of the amplifiers 4-9 is switchable between two values. The gain of amplifier 4 is switchable between the gain of 1dB and 0dB. The gain of amplifier 5 is switchable between 2dB and 0dB, that of amplifier 6 between 4dB and 0dB, that of amplifier 7 between 8dB and 0dB, that of amplifier 8 between 16dB and 0dB and that of amplifier 9 between 32dB and 0dB. The output of the detector 3, which has a linearly increasing output for a logarithmically increasing input, is converted to digital form, and the bit value on the parallel output lines of the analogue to digital converter 10 which performs the conversion is used to perform the switching of the gain. A delay 11 is provided to compensate for the delay to which the input signal is subjected in detector 3 and ADC 10.

The maximum gain which the cascaded amplifiers can produce is 63dB and the minimum is 0dB, and the gain can be adjusted in 1dB steps. Consequently, the AGC can provide correction for a 63dB variation in input signal strength. The detector 3 has a characteristic such that it produces a linearly increasing output for a logarithmically increasing input over a 63dB range. The highest voltage output of detector 3 corresponding to maximum input signal strength corresponds to all the outputs of the ADC being bit value 1 corresponding to the respective amplifiers 4-9 all being at the common value of 0dB gain. When the input signal decreases slightly in strength sufficiently for the bit value of the line connected to amplifier 4 to change to 0, then this amplifier is switched to 1dB gain to compensate for the reduced input. A further drop of input signal producing a further drop of output of detector 3 switches the line connected to amplifier 5 to 0, and its gain to 2dB while the line connected to amplifier 4 reverts to 1, switching it to 0dB. In this way, the linear output of the detector 3 is used to produce a corresponding logarithmic increase in gain of the AGC amplifier. The situation of minimum signal strength corresponds to output of ADC of 0 on all lines and hence all amplifiers switched to their respective gain values producing maximum gain.

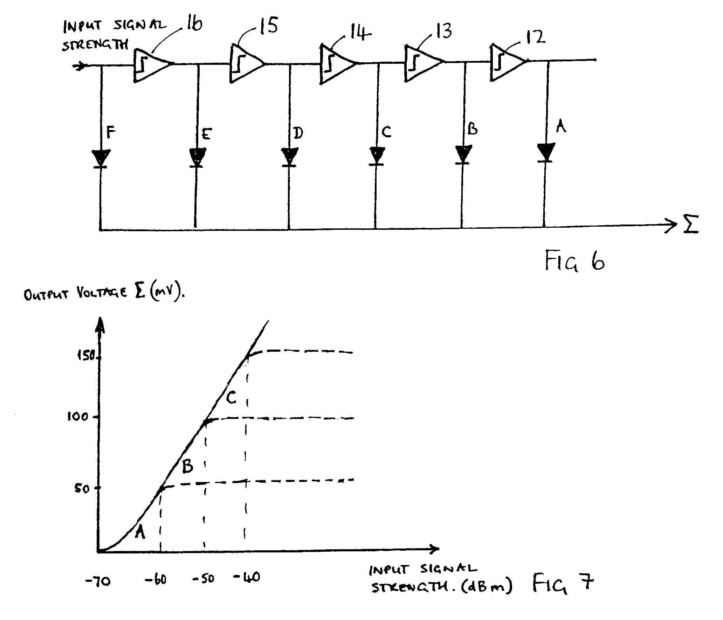

A suitable form of detector 3 is shown in Figure 6 and its characteristic is shown in Figure 7. Figure 6 shows the circuit of a successive approximation log strip. The log strip consists of amplifiers 12-16 which respectively limit when the input signal has increased by 10dB. The output (Σ) is summed via respective detectors A-F. Thus, referring to Figure 7, for the lowest input signal strength of between -70dBm and -60dBm (-60 dBm being 1 nanowatt) the output of detector A rises linearly until amplifier 12 limits (shown dotted on Figure 7) and Σ continues to linearly rise by virtue of amplifier 13 and detector B until that limits (also shown dotted) whereupon the linear rise is continued by amplifier 14 and detector C. The maximum output voltage Σ for example, approximately 300mV corresponds to all the output lines of ADC 10 being bit value 1, while the minimum output voltage of zero corresponds to all the output lines of ADC 10 being bit value 0.

The provision of a digitised received signal strength (RSSI) output for processing is an added advantage within for example a radio control system.

Referring to Figure 5, this shows a simple realisation of the arrangement of Figure 4. Only two amplifiers 8, 9 are shown, and underneath the corresponding circuitry. The input signal to the AGC is balanced, and each amplifier 9 consists of two differential pairs Q11, Q12 and Q13, Q14 oftransistors, the input signal being fed to the bases. The pairs Q11, Q12 have a gain of 0dB and the pairs Q13, Q14 a gain, for amplifier 9 of 32dB, and for amplifier 8 of 16dB. The control line from the ADC 10 is used to turn on the bias currents of the differential pairs. The bias currents I₂ has a PTAT (proportional to absolute temperature) characteristic, so that the gain of the respective transistor pairs in the sense of change of collector output current for a particular change in base emitter voltage is independent of temperature (because the transconductance gₘ of the transistors is inversely proportional to temperature).

The currents through collector resistors R_{A} drive transistors Q15, Q16. Transistors Q15, Q16 are connected in emitter follower configuration, and the emitters are used to drive the bases of Q11, Q12, Q13, Q14 ofthe next stage.

The gains of the respective differential pairs depends only on the ratio of the collector resistors R_{A} to the emitter resistors R _{B} or R _{C}. (Strictly, R_{B} or R_{C} plus the emitter resistance rₑ together with any parasitic emitter resistance, but to a first approximation the latter two terms can be ignored.) Thus, for the common gain of 0dB, R_{A}/R_{C} ≈ 1, whereas for the differential pair Q13, Q14, R_{A}/R_{B} is arranged to give a voltage gain of 32dB (16dB for amplifier 8).

AGC compensation is not time continuous as with a feedback system, hence the time when compensation occurs can be controlled by the circuit in which it is fitted e.g. by the LAN transceiver. Updating could occur during the training sequence. The value of compensation may be stored as digits rather than as a continuous voltage. If the ADC is clocked, the rate would depend on the length of the training sequence.

A major advantage ofthis topology is that the amplifier gain is dependent only on the ratio of collector resistors to the emitter degeneration resistors and therefore does not need calibration. Another possible advantage of switching between equal tail currents is the quiescent output operating point of the amplifier does not change, unlike standard AGC amplifiers where they have a tendency to move with control voltage. Using switchable bias current could also be used in power down applications. Noise (especially at 0dB with the larger values of emitter degeneration) should not be a problem as this will only occur for large input signal conditions. Similarly, gain compression should not be a problem as smaller signals would be present with the lower levels of emitter degeneration.

Set-up of the AGC system is reduced to two minor adjustments of the detector (or ADC) gain and the log slope of the detector. It is also more applicable to solutions requiring low level power supply voltages. The AGC is fast acting since it is feedforward open loop gain control, and can cover a wide dynamic range, making it suitable for LAN networks with high data rates. Further, the AGC is suitable for realisation in an The integrated circuit. The AGC operates on the signals at IF level, for example, from 10MHz to 100 MHz.

Variations may be made from the above circuit without departing from the scope of the invention. Instead of 0dB, the common value of the switched gain amplifier could be a different value. Instead of the series of values 1, 2, 4, 8, 16, 32dB for the other value of gain for the respective switched amplifiers, a different series of values may be chosen, depending on the accuracy and range of the required AGC function e.g. 2, 4, 8, 16, 32, 64dB or 3, 6, 12, 24, 48, 96dB or 3, 3, 9, 18, 36, 72dB. In the case of amplifiers with a large gain, e.g. 32dB, this could be implemented by a cascade of lower gain amplifiers e.g. 8dB+8dB+8dB+8dB. The gain figures for the switched gain amplifiers are voltage gain figures throughout, but these are easily related to power gain within the system. The invention is not solely restricted to use in LAN networks. It is not necessary for the AGC to have a logarithmic characteristic. It could have a linear or other characteristic if desired (the detector should have an inverse characteristic to that chosen for the AGC). If the AGC has a log characteristic, detectors other than successive approximation log strips may be used, also the combination of detector and ADC with a logarithmic characteristic may be used. Also, while it is convenient to control the switched gain amplifiers via the output lines of a digital signal, it is not necessary, and other control systems could be used, such as the system controller.

## Claims

1. An automatic gain control comprising an input, a detector connected to the input and arranged to detect the input signal, an AGC amplifier comprising a plurality of switched gain amplifiers arranged in cascade, the gain of each of which can be switched between one of a series of values and a common value, in response to signals derived from the output ofthe detector, and a delay connected in series between the input and the AGC amplifier to compensate for the delay between the instantaneous value of the input signal and the switching of the amplifiers in response to that instantaneous value.

2. An automatic gain control as claimed in claim 1, in which the detector has a characteristic such that the output increases linearly for logarithmic increase of the input.

3. An automatic gain control as claimed in claim 2, including a multi-bit analogue to digital converter having as its input a signal derived from the output of the detector and as its output a plurality of lines the bit value of which is operative to control a respective one of the switched gain amplifiers.

4. An automatic gain control as claimed in any one of claims 1 to 3, in which the series of values of gain when expressed in dB form a binary series or a multiple of a binary series.

5. An automatic gain control as claimed in any one of claims 1 to 4, in which the switched gain amplifiers include bipolar transistors in a common emitter configuration, the bias current of which is proportional to absolute temperature.

6. A wireless local area network including an automatic gain control as claimed in any one of claims 1 to 5.
